# FASCICULE DE BREVET EUROPEEN

(11) **EP 0 308 348 B1**
(45) Date de publication et mention de la délivrance du brevet: **10.02.1993**
(21) Numéro de dépôt: 88402348.2
(22) Date de dépôt: 16.09.1988
(51) Int. Cl.: G12B 9/08, B23Q 1/16

(54) **Appareil manipulateur de tête de test pour équipement de test automatique**
Prüfkopfmanipulator für das automatische Prüfen
Test head robot for automatic testing

(30) Priorité: 17.09.1987 FR 8713098; 17.09.1987 FR 8713099
(43) Date de publication de la demande: 22.03.1989
(73) Titulaire: SCHLUMBERGER INDUSTRIES, F-92120 Montrouge (FR)
(72) Inventeur: Beaucoup, Louis, F-42000 Saint-Etienne (FR); Boncompain, Jean, F-42100 Saint-Etienne (FR)
(74) Mandataire: Ropital-Bonvarlet, Claude

(56) Documents cités:
- FR-A- 2 306 769
- US-A- 4 270 721
- US-A- 4 522 380

## Description

L'invention est relative au domaine technique des appareils manipulateurs conçus pour le support et l'orientation d'une tête de test électronique assurant l'interface de connexion entre un équipement de test automatique et des circuits électroniques, simples ou complexes, à tester, chargés sur une structure de présentation.

Les appareils du type ci-dessus sont destinés à permettre le réglage de position en site, en azimut et en orientation d'un support sur lequel la tête est montée, de manière à permettre, par déplacement manuel, l'accostage et la connexion de cette tête avec la structure de présentation des circuits électroniques à tester.

Les têtes de test électroniques sont des ensembles de poids élevé formés d'une structure de support et de protection contenant un grand nombre de circuits de contrôle prolongés extérieurement à la tête par des câbles de connexion. Chaque circuit intégré à tester est successivement placé sur la tête de test en provenance d'une structure de présentation à laquelle la tête est mécaniquement connectée. Généralement, de telles têtes sont organisées sous forme de caissons de forme approximativement parallélépipédique susceptibles d'être supportés par deux tourillons fixés de part et d'autre du caisson. Comme le poids de la tête est uniformément réparti par rapport à ces tourillons, la tête est suspendue en équilibre indifférent par les deux tourillons.

D'autres têtes de test électroniques qui seront appelées ici "asymétriques" comprennent une enveloppe cylindrique prolongée radialement par un bras rigide qui contient des câbles de connexion électriques et des conduites de refroidissement.

Les manipulateurs de têtes de test connus, comme celui décrit dans la demande de brevet européen EP-A-102 217, comprennent un support en forme de "U" ou berceau adapté à recevoir une tête de test parallélépipédique dans une position équilibrée de façon que la tête puisse être basculée manuellement sans efforts autour de deux axes perpendiculaires. Si ces manipulateurs peuvent être considérés comme donnant relativement satisfaction pour des têtes de test parallélépipédiques, ils ne conviennent pas pour les têtes de test de type "asymétrique" décrites ci-dessus.

En supposant qu'on dispose des tourillons de part et d'autre de l'enveloppe d'une tête de test prolongée par un bras radial, de tels tourillons ne permettraient pas de supporter la tête dans un état d'équilibre indifférent. De plus, une rotation de 180° de la tête de test ne serait pas possible autour de ces tourillons du fait du bras radial qui viendrait buter sur le berceau de support.

En d'autres termes, les manipulateurs connus ne permettent pas le déplacement des têtes de test de type "asymétrique" avec le nombre désiré de degrés de liberté pour permettre un accostage précis et sûr de la tête de test sur la structure de présentation des circuits à tester.

Une caractéristique souhaitable importante d'un manipulateur est de pouvoir faire tourner la tête de test de 180° autour d'un axe pour avoir accès à sa face inférieure. Une autre caractéristique importante est de pouvoir faire basculer la tête de test autour d'un autre axe, de préférence perpendiculaire au premier. Une troisième propriété souhaitable importante est de pouvoir installer la tête de test ou la dégager du manipulateur facilement et sans avoir à la déconnecter de l'équipement de test automatique. Ces caractéristiques ne peuvent pas être obtenues avec les manipulateurs connus lorsqu'on les utilise avec des têtes de test du type "asymétrique".

Un objet de l'invention est de fournir un manipulateur adapté aux têtes de test du type "asymétrique". En plus de sa faculté de permettre le déplacement manuel d'une tête de test à n'importe quelle position horizontalement et verticalement, le manipulateur de l'invention autorise la rotation d'une tête du type asymétrique autour de deux axes, l'une de ces rotations autour du bras radial étant libre et importante (de l'ordre de 180°) tandis que l'autre, perpendiculaire à ce bras, est commandée et plus limitée (de l'ordre de 10°).

Un autre avantage important de l'invention est de pouvoir installer la tête de test sur le manipulateur ou de l'en dégager sans avoir à déconnecter les câbles de liaison électriques.

Selon l'invention, un appareil manipulateur pour le support et l'orientation d'une tête de test prolongée par un bras radial comprend des moyens de suspension pour monter mobile verticalement un bloc ; des moyens de positionnement pour monter mobile horizontalement le bloc ; un dispositif d'orientation pour monter la tête de test sur le bloc ; et des moyens d'équilibrage pour équilibrer le poids de la tête de test montée sur le dispositif d'orientation. Le dispositif d'orientation est monté tournant sur le bloc autour d'un axe horizontal (ϑx) et adapté à monter le bras radial de la tête de test mobile en rotation autour d'un axe supplémentaire (ϑy) perpendiculaire à l'axe horizontal (ϑx) et des moyens de réglage sont prévus pour maintenir, par rapport au bloc, le dispositif d'orientation dans une position angulaire réglable stable autour de l'axe horizontal (ϑx) afin d'empêcher la tête de test de basculer autour de cet axe horizontal (ϑx) sous l'effet de son poids.

De préférence le dispositif d'orientation comprend un cadre monté tournant sur le bloc autour de l'axe horizontal (ϑx), des organes de centrage disposés sur le cadre à égales distances de l'axe supplémentaire (ϑy) et une galette montée en appui sur les organes de centrage pour pouvoir tourner autour de l'axe supplémentaire (ϑy), le bras radial de la tête de test étant fixé à la galette.

En outre, le cadre comprend une première partie montée tournante sur le bloc autour de l'axe horizontal (ϑx) et adaptée à entourer partiellement la galette et une deuxième partie montée pivotante par rapport à la première partie entre une position fermée pour laquelle la galette est maintenue entre les deux parties du cadre et une position ouverte pour laquelle la galette peut être dégagée du cadre avec la tête de test fixée à la galette.

Diverses autres caractéristiques ressortiront de la description faite ci-dessous en référence aux dessins annexés qui montrent, à titre d'exemples non limitatifs, des formes de réalisation de l'objet de l'invention.

La figure 1 est une vue schématique en perspective illustrant un appareil manipulateur de support et d'orientation d'une tête de test électronique conforme à l'invention.

La figure 2 est une élévation en coupe partielle de la colonne et des moyens d'équilibrage de l'appareil de la figure 1.

Les figures 3, 4, 5 et 6 sont des vues en plan, en coupe partielle, prises respectivement selon les lignes III-III, IV-IV, V-V et VI-VI de la figure 2.

La figure 7 est une coupe-élévation en partie arrachée du dispositif d'orientation de l'appareil de la figure 1.

La figure 8 est une vue en plan, en partie arrachée, prise selon la ligne VIII-VIII de la figure 7.

La figure 9 est une coupe transversale selon la ligne IX-IX de la figure 7.

La figure 10 est une coupe-élévation partielle montrant, à plus grande échelle, une variante de réalisation des moyens de réglage de l'appareil manipulateur.

La figure 11 est une coupe prise selon la ligne XI-XI de la figure 10.

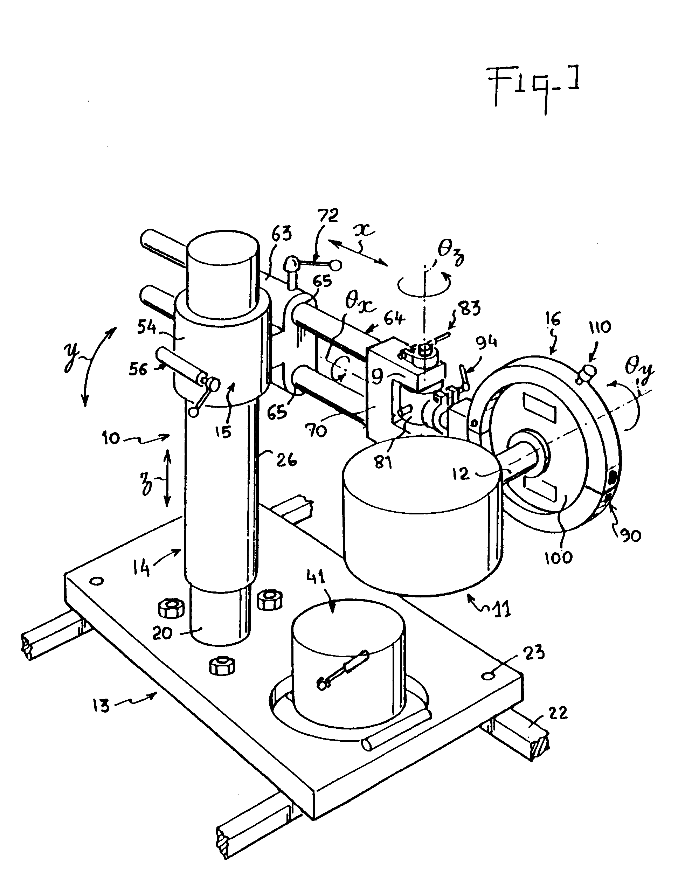

La figure 1 montre, de façon schématique, un appareil manipulateur 10 pour le support et l'orientation d'une tête de test électronique 11, du type asymétrique, pourvue d'un bras radial de fixation 12.

Un appareil, tel que 10, comprend, généralement, un socle 13 à partir duquel s'élève une colonne de suspension 14 pourvue de moyens de positionnement 15 capables d'assurer le déplacement d'un dispositif d'orientation 16 selon des directions générales x, y et z. Les moyens de positionnement 15 permettent de déplacer la tête de test 11 selon trois mouvements : une rotation (y) autour de la colonne 14, un mouvement de translation le long d'une direction horizontale (x) et une rotation autour d'un axe vertical (ϑz). Ajoutés au déplacement vertical autorisé par la colonne de suspension 14, ces trois mouvements permettent d'amener la tête de test 11 à n'importe quelle position tout autour de la colonne 14. Le dispositif d'orientation 16 permet deux mouvements supplémentaires de la tête de test 11 : une rotation autour d'un axe horizontal ϑx et une rotation autour d'un axe ϑy.

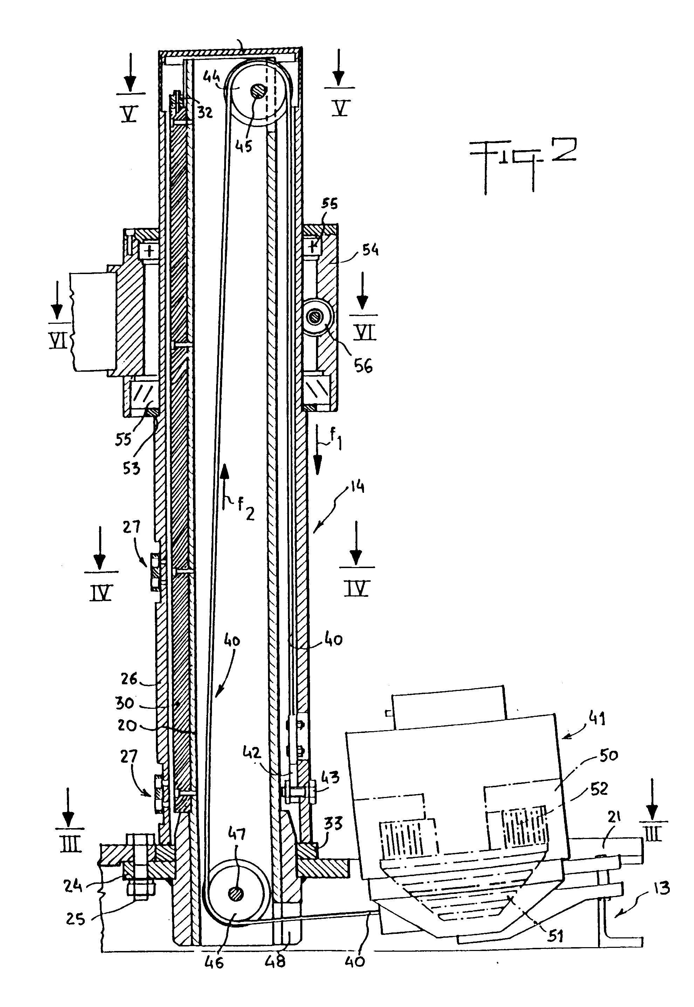

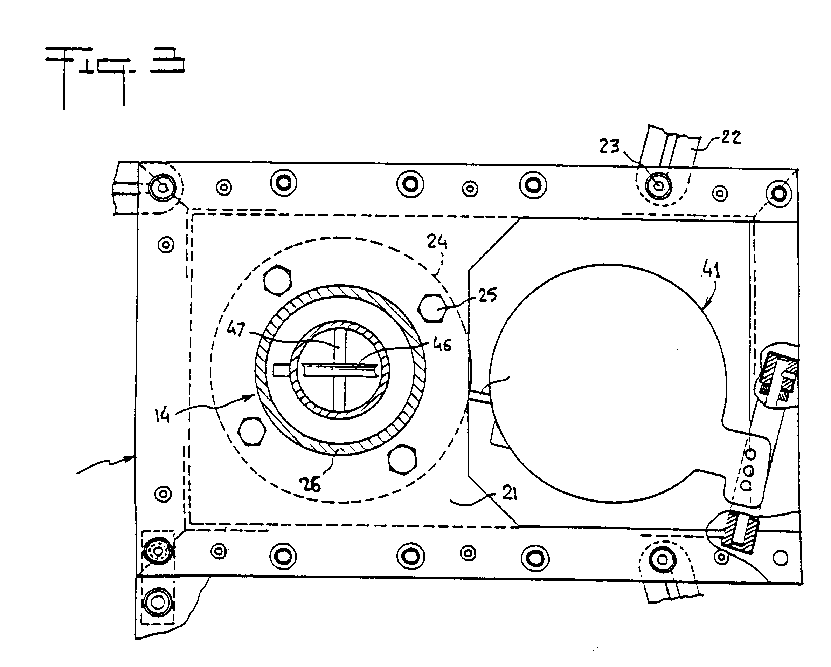

La colonne 14 comprend un organe de suspension fixe ou fût tubulaire 20 fixé au socle 13. Comme représenté sur les figures 2 et 3, le socle 13 comprend une embase 21, de toute forme géométrique appropriée, associée à des pieds 22 montés orientables sur des axes d'articulation verticaux 23. Les pieds 22 ne sont représentés que partiellement aux figures 1 et 3. Ils peuvent être réalisés de toute façon convenable en étant de longueur fixe ou réglable.

Comme représenté sur la figure 2, le fût tubulaire fixe 20 est fixé, par tout moyen convenable, sur l'embase 21. De préférence, le fût 20 comporte en pied une collerette 24 par laquelle il est fixé sur l'embase 21, notamment par l'intermédiaire de boulons 25.

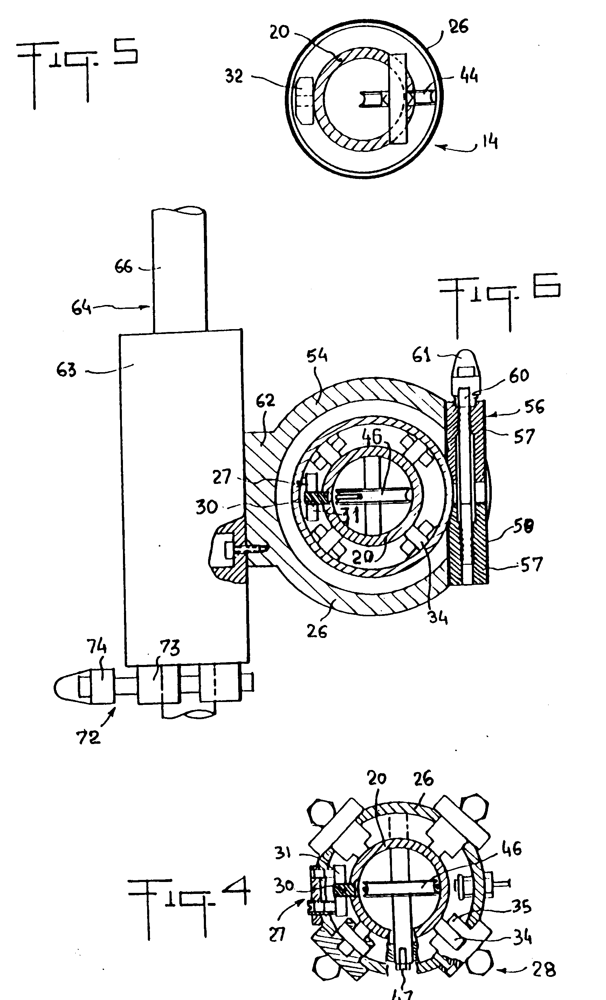

La colonne 14 comprend, par ailleurs, un organe de suspension mobile ou fourreau tubulaire 26 enfilé concentriquement sur le fût 20 avec lequel il coopère par des organes de guidage 27 et par des organes de centrage 28, illustrés plus en détail à la figure 4.

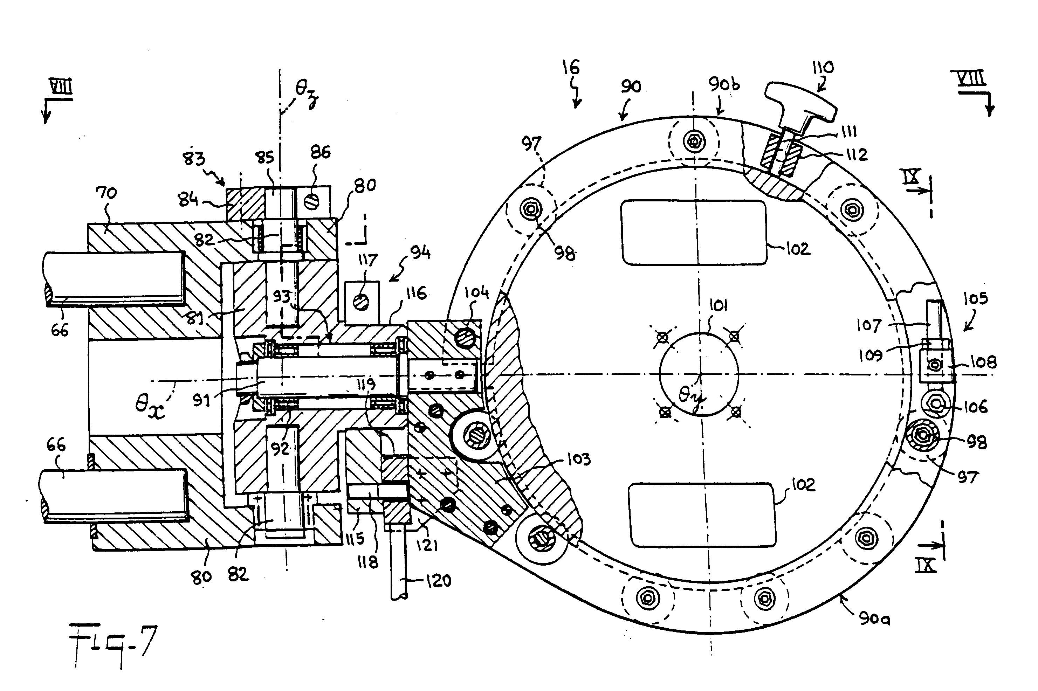

Les organes de guidage 27 empêchent le fourreau 26 de tourner autour du fût 20. Ils comprennent une règle axiale 30 qui est fixée à la périphérie du fût tubulaire fixe 20. Les organes 27 comprennent, par ailleurs, au moins deux jeux de deux galets 31 portés par le fourreau 26, de manière à coopérer pour chaque paire avec les deux faces latérales de la règle axiale 30. Les deux paires de galets 31 sont disposées à distance l'une de l'autre, à partir de l'extrémité inférieure du fourreau tubulaire 26 de manière à pouvoir coopérer avec la majeure partie de la longueur de la règle 30 et permettre ainsi le déplacement axial télescopique du fourreau 26 sur la majeure partie utile de la hauteur du fût tubulaire 20. La position d'extension maximale du fourreau 26 par rapport au fût 20 est déterminée par un taquet de butée 32 (figure 5) adapté à l'extrémité supérieure de la règle 30 pour s'opposer au déplacement des galets 31 de la paire supérieure 27. La position de rétraction maximale, telle qu'illustrée par la figure 2, est déterminée par l'amenée en butée de l'extrémité basse du fourreau 26 contre l'embase 21, soit directement, soit avec interposition d'une garniture 33, par exemple en élastomère, assumant une fonction de couronne d'appui et d'amortissement.

Les organes de centrage 28 sont principalement constitués par des galets 34 montés sur des chapes 35 portées par le fourreau 26 de manière à pouvoir rouler axialement sur la périphérie extérieure du fût 20. Les galets 34 sont organisés en deux séries distantes axialement d'une mesure, par exemple, égale à celle séparant les deux paires de galets 31. Les galets 34 sont équidistants angulairement dans chaque série. La figure 4 montre que, de façon préférée, chaque série comporte quatre galets 34 deux à deux diamétralement opposés. Les chapes 35 peuvent être réalisées de différentes façons possibles. Une structure appropriée consiste à leur faire comporter une collerette par laquelle elles sont fixées de façon amovible sur la surface extérieure du fourreau 26 que les chapes traversent librement.

Le fourreau 26 est ainsi guidé axialement et angulairement, tout en étant centré sur le fût 20 par rapport auquel il peut être déplacé avec un frottement minimal, en raison de la présence des galets 31 et 34. Le fourreau 26 peut ainsi être placé dans la position de rétraction correspondant à la hauteur minimale de la colonne 14 tel que cela est illustré par la figure 2. Par contre, le fourreau 26 peut aussi être élevé aisément jusque dans sa position d'extension maximale par coulissement télescopique jusqu'à la position de butée déterminée par l'appui de la première paire de galets 31 contre le taquet 32. Pour assurer et régler un tel coulissement, certains au moins des galets 31 et 34 sont montés par des bagues excentriques sur leurs axes.

Le manipulateur comprend des moyens d'équilibrage de poids de la tête de test. Le fourreau 26 est relié, par une transmission souple 40, à des moyens de traction réglables 41 portés par l'embase 21. La transmission souple 40 comprend un câble dont l'oeilleton d'extrémité 42 est accroché, par un moyen de fixation 43, à l'intérieur du fourreau 26 et à proximité de l'extrémité basse de ce dernier. Le câble 40 s'élève dans l'intervalle annulaire entre le fourreau 26 et le fût 20, pour être pris en charge par une poulie de renvoi 44 portée par un axe de rotation 45 fixé en tête du fût 20. Au-delà de la poulie 44, le câble 40 s'étend axialement à l'intérieur du fût 20 et passe sur une poulie de renvoi de pied 46 portée par un axe de rotation 47 fixé à la base du fût 20. Au-delà de la poulie de renvoi de pied 46, le câble 40 est orienté de façon sensiblement horizontale, à travers une lumière 48 du fût 20 pour être pris en charge par les moyens de traction 41.

Selon une disposition de l'invention, les moyens de traction 41 appliquent une traction élastique réglable au câble 40. Les moyens de traction 41 comprennent une enveloppe 50 fixée à l'embase 21 et contenant un tambour 51 ayant une gorge hélicoïdale à diamètre de spire progressivement croissant sur laquelle s'enroule le câble 40. Lorsque le fourreau 26 est en position haute, toutes les spires du câble 40 sont enroulées sur le tambour 51. Dans l'enveloppe 50, les moyens de traction 41 comprennent aussi un ressort à lame 52 du type spiral dont la main d'accrochage interne est ancrée sur le tambour 51. Le réglage des moyens de traction 41 est effectué, selon le poids de la tête de test, de manière à amener verticalement la tête de test à une position neutre choisie pour laquelle l'action de traction élastique compense le poids de l'équipage mobile incluant la tête, ce poids s'appliquant au câble 40 dans le sens des flèches f₁ et f₂.

Le tambour 51 est réalisé pour compenser les variations de force du ressort spiral 52 lorsque le câble est enroulé ou déroulé du tambour 51. Par conséquent, la force appliquée par les moyens de traction 41 est sensiblement constante sur une plage de positions verticales de part et d'autre de la position neutre. La tête de test peut ainsi être déplacée verticalement sans effort sur cette plage de positions pour être amenée à son emplacement précis d'accostage.

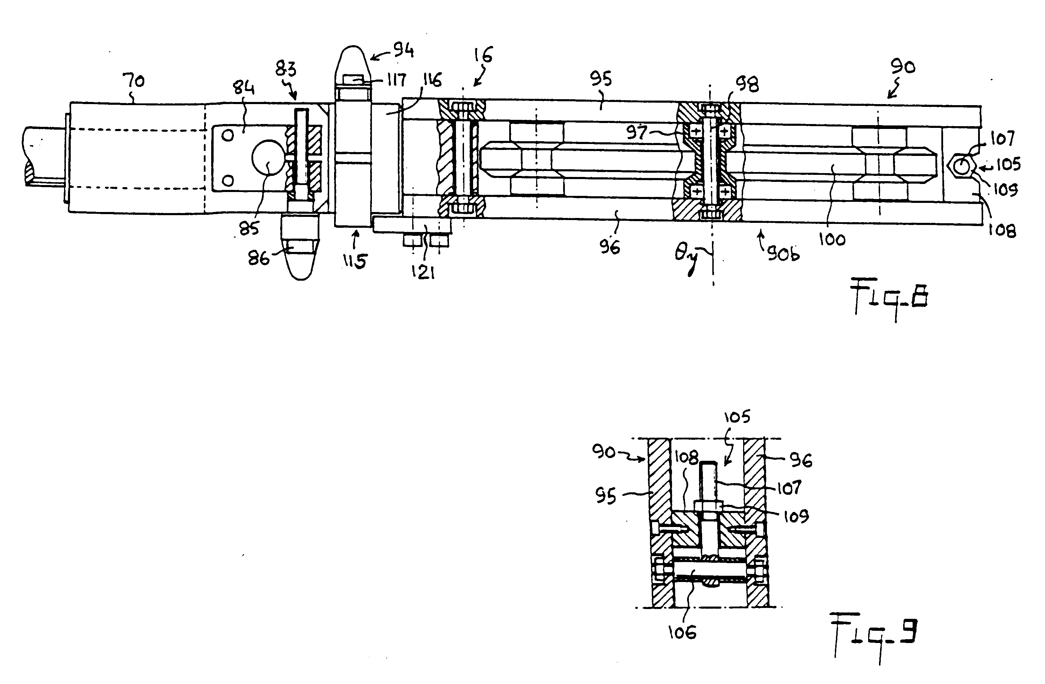

Le fourreau 26 comporte, à distance de son extrémité supérieure, un épaulement 53 sur lequel prend appui axialement une bague support 54 par ailleurs centrée sur le fourreau 26 par l'intermédiaire d'un roulement et d'une butée à billes ou à rouleaux 55. La bague 54 peut ainsi tourner librement avec un frottement minimal par rapport au fourreau 26 et sur une plage angulaire égale à 360°. La bague 54 est associée (figure 6) à un mécanisme 56 de blocage angulaire, de tout type convenable. De préférence, le mécanisme 56 est constitué par un ou deux manchons tubulaires cylindriques 58 traversant, de façon sécante, la bague 54 et assurant le guidage axial de deux noix 57 vissées sur des parties filetées à pas inverse d'une tige de commande 60 pourvue d'une poignée 61 d'entraînement en rotation. Le ou les manchons 58 sont réalisés de manière que les noix 57 puissent faire partiellement saillie au-delà d'eux, afin de pouvoir être amenées à serrer le fourreau 26 lorsque, par rotation de la tige 60 dans le sens correspondant, elles sont sollicitées en rapprochement mutuel axial à l'intérieur du manchon 58.

Le mécanisme 56 permet d'immobiliser très précisément la bague 54 selon une orientation angulaire quelconque.

La bague 54 porte, par une platine 62, de préférence diamétralement opposée au mécanisme 56, un corps 63 de guidage d'un bras horizontal 64 de support d'une tête de test électronique. Le corps de guidage 63 définit au moins une et, de préférence, deux coulisses 65 parallèles entre elles, superposées, disposées dans un même plan vertical parallèle à l'axe de la colonne et déportées par rapport à ce dernier. Les coulisses 65 assurent le support et le guidage de deux barres 66 constitutives du bras 64. Les barres 66 sont réunies, à une de leurs extrémités, par un corps 70 d'articulation du dispositif d'orientation 16. Le corps de guidage 63 est pourvu d'au moins un mécanisme 72 d'immobilisation axiale du bras 64. Le mécanisme 72 peut être constitué par une bride ouverte 73 associée à un organe de serrage 74 du type à vis et traversé par au moins une glissière 66. Le serrage de la vis 74 ferme la bride ouverte 73 qui serre la glissière 66, de cette façon immobilisée axialement par rapport au corps 63.

La colonne 14 décrite ci-dessus se caractérise par un faible encombrement vertical dû à sa réalisation au moyen d'un fût fixe tubulaire 20 et d'un fourreau télescopique 26 immobilisé angulairement sur le fût. La possibilité de coulissement axial du fourreau 26 permet de placer la bague 54 soit dans une position de hauteur minimale telle qu'illustrée par la figure 2, soit en toute position intermédiaire jusqu'à une hauteur maximale correspondant à l'extension du fourreau 26 par rapport au fût 20 et limitée par le taquet de butée 32.

La bague 54 permet d'orienter le bras 64 en toutes positions angulaires sur une plage de 360°, ce bras pouvant être immobilisé à volonté dans n'importe quelle orientation.

La disposition du corps de guidage 63 déporté latéralement par rapport à l'axe de rotation verticale de la bague 54 permet de dégager le bras 64 de l'aplomb du socle 13 lorsqu'il convient d'aménager ou de faciliter l'approche relative de la tête par rapport à l'unité de traitement de l'équipement de test ou à la structure de présentation des circuits à tester.

L'existence d'un bras 64 en porte-à-faux constitué, de préférence, par deux barres situées dans un même plan vertical, contribue à assurer un maintien particulièrement stable d'une tête de test, même d'un poids très élevé.

Les moyens de traction réglable 41 de faible encombrement et dont la fonction d'équilibrage de poids s'effectue par application d'une traction élastique compensée permet à l'utilisateur un réglage facile et continu, en fonction du poids de la tête de test, sans nécessiter de manipulation de masses d'équilibrage.

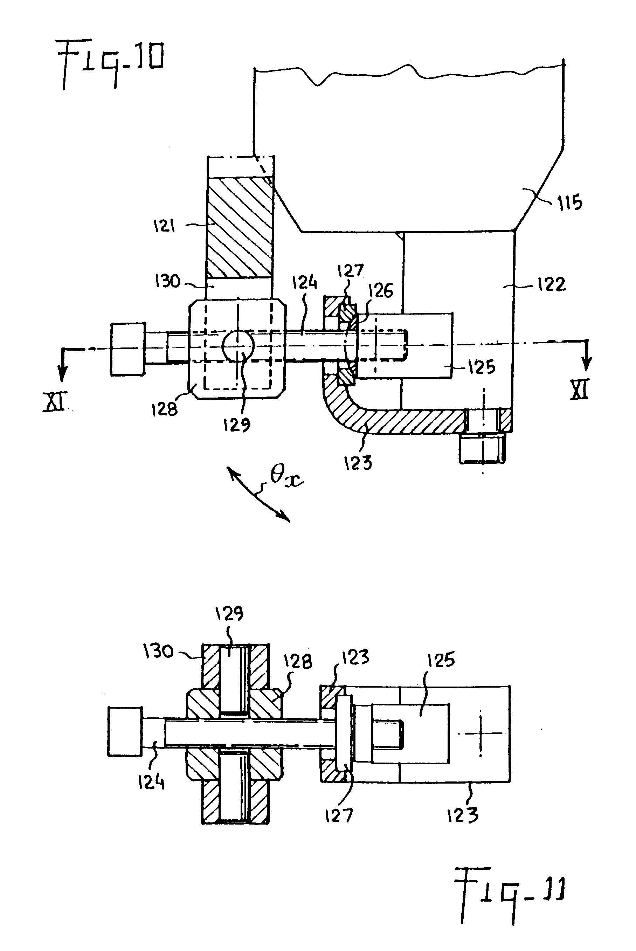

En référence aux figures 7 et 8, le corps d'articulation 70 fixé à l'extrémité des glissières 66 est réalisé sous la forme générale d'un étrier disposé, habituellement, pour que les branches parallèles 80 qu'il comporte soient superposées verticalement. Un bloc d'adaptation 81 est monté tournant sur le corps d'articulation 70. Le bloc d'adaptation 81 est monté entre les branches 80 par l'intermédiaire de deux tourillons 82 qui définissent un axe de rotation vertical ϑz, généralement parallèle à la colonne 14. Différentes solutions techniques peuvent être choisies pour assurer le support et la rotation libre du bloc 81 entre les branches 80 par l'intermédiaire des tourillons 82. La rotation libre, entre le bloc 81 et le corps 70, peut être bloquée par l'intermédiaire d'un moyen de blocage angulaire 83 à commande manuelle. Le moyen de blocage 83 est, par exemple, constitué par une bride ouverte 84 fixée sur la branche supérieure 80 du corps 70 pour entourer un prolongement 85 du tourillon supérieur 82. La bride 84 est associée à un organe de serrage 86 capable de l'ouvrir ou de la fermer, pour libérer ou bloquer angulairement le prolongement 85 du tourillon 82 angulairement immobilisé sur le bloc 81.

Le dispositif d'orientation 16 comporte un cadre annulaire ou lunette 90 pourvue extérieurement d'une queue cylindrique 91 de direction radiale qui est montée, par l'intermédiaire de roulements 92, dans un palier 93 du bloc 81, définissant un axe de rotation ϑx de direction sensiblement horizontale coupant l'axe ϑz. Le bloc 81 supporte des moyens 94 de réglage et de maintien en position angulaire de la lunette 90 sur l'axe ϑx qui seront décrits par la suite.

La lunette 90 est, de préférence, constituée par deux anneaux 95 et 96 (figure 8) maintenus parallèlement par des entretoises 98. Les anneaux parallèles 95 et 96 retiennent entre eux des organes de centrage 97 qui sont constitués par des galets montés libres de tourner sur les entretoises 98. Les organes de centrage 97 sont prévus pour assurer le support et le centrage d'une galette 100 circulaire en définissant, pour cette dernière, un axe de rotation ϑy confondu avec l'axe géométrique de la lunette 90. De préférence, les galets 97 sont réalisés sous forme de diabolos emboîtant le bord périphérique complémentaire de la galette 100. A titre d'exemple, la galette 100, plus particulièrement destinée au support de la tête de test électronique 11, comporte en son centre des moyens 101 d'adaptation et de fixation du bras 12 et des fenêtres 102 de passage et/ou de raccordement de connecteurs électriques issus de la tête 11.

De manière à faciliter le montage et/ou le changement de la galette 100, la lunette 90 est, de préférence, constituée par un premier arceau 90a, dit fixe, s'étendant à partir d'une chape 103 portant la queue 91. La chape 103 est pourvue d'un axe de pivotement 104 parallèle à l'axe de rotation ϑy. L'axe 104 porte un second arceau 90b susceptible de pivoter dans le plan vertical d'une position d'ouverture dans laquelle il dégage, par rapport à l'arceau fixe, une section de passage au moins égale au diamètre de la galette 100, à une position de fermeture dans laquelle il reconstitue la lunette 90 avec l'arceau 90a. La liaison d'assemblage temporaire entre les arceaux 90a et 90b est assurée par un organe 105, par exemple constitué par un axe 106 monté tourillonnant entre les demi-anneaux constitutifs de l'arceau 90a. L'axe 106 est prolongé par une tige filetée radiale 107 destinée à s'engager dans une fourchette 108 derrière laquelle prend appui un écrou de serrage 109 (figure 9).

Les arceaux 90a et 90b sont chacun constitués par des demi-anneaux assemblés entre eux, comme dit précédemment, et assurant le maintien des organes de centrage 97 qu'ils portent.

La lunette 90 est pourvue d'un organe 110 de blocage angulaire de la galette 100 sur l'axe de rotation ϑy. Un tel organe 110 est, par exemple, constitué par une vis de pression 111 traversant un écrou fixe 112 porté par la lunette 90, de manière à prendre appui, selon une direction radiale, sur le bord périphérique de la galette 100. Il est évident que des moyens techniques différents pourraient être envisagés pour assumer la même fonction.

Comme mentionné précédemment, le manipulateur comprend des moyens 94 de réglage et de maintien en position angulaire de la lunette 90 sur l'axe ϑx.

Les moyens de réglage 94 peuvent comporter une bride ouverte 115 qui est montée fixe sur une portée cylindrique 116 formée par le bloc d'adaptation 81 concentriquement à l'axe du palier 93. La bride ouverte 115 est immobilisée angulairement sur la portée 116 par l'intermédiaire d'une vis 117 traversant les deux branches de ladite bride délimitée par la fente qu'elle présente.

A l'opposé de la vis 117, la bride 115 porte un axe 118 sur lequel est montée une came excentrique 119 libre de tourner. La came excentrique 119 est prolongée par une tige de manoeuvre 120 et sa surface externe vient en appui sur une plaque 121 portée par la chape 103 de la lunette 90.

Lorsque l'excentrique 118 tourne autour de son axe 118, il écarte plus ou moins la plaque 121 de la bride 115, ce qui déplace en rotation la lunette 90 par rapport au bloc 81 autour de l'axe ϑx.

Une variante de réalisation, illustrée par les figures 10 et 11, montre que la bride 115 peut porter à sa partie inférieure un pied 122 portant une barrette de butée 123 traversée librement par une vis 124 du type micrométrique. A une extrémité de la vis 124 est fixé un écrou 125 prenant appui derrière la butée 123 par une portée en calotte sphérique 126 emboîtée dans un siège complémentaire 127 de la butée. La vis 124 coopère, en avant de la butée 123, avec une noix taraudée 128 montée libre de pivoter par des tourillons 129 parallèles à l'axe ϑx du palier 93 sur une chape 130 définie par la plaque 121 ou tout autre pièce analogue portée par la chape 103.

Avec l'un ou l'autre de ces modes de réalisation, l'utilisateur peut procéder au réglage angulaire de la position autour de l'axe ϑx, de la lunette 90 portant la tête de test tout en empêchant la lunette 90 de basculer autour de cet axe sous l'effet du poids en déséquilibre de la tête.

Ce réglage est limité à une certaine plage de positions angulaires de la lunette 90 autour de l'axe ϑx. Dans les modes de réalisation décrits, la plage de réglage possible allait de + 5° à - 5° autour de la position de la lunette 90 pour laquelle l'axe ϑy était horizontal.

Ainsi que cela ressort de ce qui précède, le manipulateur comporte un dispositif d'orientation 16 particulièrement adapté au support d'une tête de test électronique, du type asymétrique, comportant un bras de fixation radial fixe dans la galette 100. Une telle tête, ainsi que cela ressort de la figure 1, peut ainsi être aisément fixée en porte-à-faux, de telle manière que son bras radial 12 soit aligné avec l'axe de rotation ϑy autour duquel la tête 11 peut être orientée, de façon simple et aisée, par rotation de la galette 100. La galette peut être immobilisée angulairement par l'organe de blocage 110.

La tête 11 peut aussi être réglée et orientée autour de l'axe de rotation ϑx, avec un mouvement limité, en faisant tourner la lunette 90 sur cet axe par les moyens de réglage 94.

Le dispositif selon l'invention assure ainsi de façon pratique, rapide, efficace, le support d'une tête de type asymétrique à bras radial de fixation en porte-à-faux tout en permettant de déplacer manuellement cette tête selon les différents degrés de liberté désirés.

On remarquera qu'à l'exception des moyens de réglage 94, les différents blocages peuvent être tous libérés après le positionnement de la tête et son accostage à un dispositif de présentation des circuits à tester. La tête garde alors sa position, sans subir de contraintes de la part du manipulateur.

## Revendications

1. Appareil manipulateur pour le support et l'orientation d'une tête de test (11) prolongée par un bras radial (12) comprenant :
- des moyens de suspension (14) pour monter mobile verticalement un bloc (81) ;
- des moyens de positionnement (15) pour monter mobile horizontalement le bloc (81) ;
- un dispositif d'orientation (16) pour monter la tête de test sur le bloc (81) ; et
- des moyens d'équilibrage (40, 41) pour équilibrer le poids de la tête de test (11) montée sur le dispositif d'orientation (16) ;
caractérisé en ce que le dispositif d'orientation (16) est monté tournant sur le bloc (81) autour d'un axe horizontal (ϑx) et adapté à monter le bras radial (12) de la tête de test (11) mobile en rotation autour d'un axe supplémentaire (ϑy) perpendiculaire à l'axe horizontal (ϑx) et en ce que des moyens de réglage (94) sont prévus pour maintenir, par rapport au bloc (81), le dispositif d'orientation (16) dans une position angulaire réglable stable autour de l'axe horizontal (ϑx) afin d'empêcher la tête de test de basculer autour de cet axe horizontal (ϑx) sous l'effet de son poids.

2. Appareil selon la revendication 1, caractérisé en ce que le dispositif d'orientation comprend un cadre (90) monté tournant sur le bloc (81) autour de l'axe horizontal (ϑx), des organes de centrage (97) disposés sur le cadre (90) à égales distances de l'axe supplémentaire (ϑy) et une galette (100) montée en appui sur les organes de centrage (97) pour pouvoir tourner autour de l'axe supplémentaire (ϑy), le bras radial (12) de la tête de test (11) étant fixé à la galette (100).

3. Appareil selon la revendication 2, caractérisé en ce que le cadre (90) comprend une première partie (90a) montée tournante sur le bloc (81) autour de l'axe horizontal (ϑx) et adaptée à entourer partiellement la galette (100) et une deuxième partie (90b) montée pivotante par rapport à la première partie (90a) entre une position fermée pour laquelle la galette (100) est maintenue entre les deux parties du cadre (90) et une position ouverte pour laquelle la galette (100) peut être dégagée du cadre (90) avec la tête de test (11) fixée à la galette.

4. Appareil selon la revendication 3, caractérisé en ce que la deuxième partie (90b) du cadre (90) est montée pivotante sur la première (90a) autour d'un axe (104) parallèle à l'axe supplémentaire (ϑy), le cadre (90) comprenant de plus des moyens (105) pour verrouiller les première et deuxième parties (90a, 90b) dans la position fermée.

5. Appareil selon l'une des revendications 2 à 4, caractérisé en ce que les organes de centrage (97) comprennent des galets disposés tout autour de l'axe supplémentaire (ϑy) et ayant des surfaces adaptées à maintenir latéralement la galette (100) dans la direction de l'axe supplémentaire (ϑy).

6. Appareil selon l'une des revendications 2 à 5, caractérisé en ce qu'il comprend un organe de blocage (110) à commande manuelle, monté sur le cadre (90) pour empêcher la rotation de la galette (100) autour de l'axe supplémentaire (ϑy).

7. Appareil selon la revendication 1, caractérisé en ce que les moyens de réglage (94) comprennent des moyens de liaison manuellement réglables disposés entre le bloc (81) et le dispositif d'orientation (16) pour déplacer en rotation le dispositif d'orientation (16) par rapport au bloc (81) autour de l'axe horizontal (ϑx) sur une plage limitée de positions angulaires.

8. Appareil selon la revendication 7, caractérisé en ce que la plage limitée de positions angulaires est de l'ordre de 10°.

9. Appareil selon l'une des revendications 7 et 8, caractérisé en ce que les moyens de réglage (94) comprennent une vis réglable (124) reliant le bloc (81) au dispositif d'orientation (16) de façon qu'une rotation manuelle de la vis (124) entraîne la rotation du dispositif d'orientation (16) par rapport au bloc (81) autour de l'axe horizontal (ϑx).

10. Appareil selon l'une des revendications 7 et 8, caractérisé en ce que les moyens de réglage (94) comprennent une came (119) montée tournante sur le bloc (81) autour d'un axe (118) parallèle à l'axe horizontal (ϑx) et venant en appui sur le dispositif d'orientation (16) de façon qu'une rotation manuelle de la came (119) entraîne la rotation du dispositif d'orientation (16) par rapport au bloc (81) autour de l'axe horizontal (ϑx).

11. Appareil selon l'une des revendications précédentes, caractérisé en ce que les moyens de positionnement (15) comprennent un premier support (54) monté mobile en rotation autour d'un premier axe vertical et un deuxième support (70) monté mobile horizontalement par rapport au premier support (54), le bloc (81) étant monté tournant sur le deuxième support (70) autour d'un deuxième axe vertical (ϑz).

12. Appareil selon la revendication 11, caractérisé en ce que les moyens de suspension comprennent un premier organe tubulaire (20) fixé à un socle et un deuxième organe tubulaire (26) monté de façon à coulisser verticalement le long du premier organe tubulaire (20), le premier support (54) étant monté tournant autour du deuxième organe tubulaire (26).

## Claims

1. Manipulator apparatus for the support and orientation of a test head (11) extended by a radial arm (12) comprising:
- suspension means (14) for mounting a block (81) in vertically movable manner;
- positioning means (15) for mounting the block (81) in horizontally movable manner;
- an orientation device (16) for mounting the test head on the block (81); and
- balancing means (40, 41) for balancing the weight of the test head (11) mounted on the orientation device (16);
characterized in that the orientation device (16) is mounted on the block (81) for rotating about a horizontal axis (ϑx) and is adapted for mounting the radial arm (12) of the test head (11) so that it is rotatably movable about an additional axis (ϑy) perpendicular to the horizontal axis (ϑx) and in that adjusting means (94) are provided for holding, relative to the block (81), the orientation device (16) in a stable adjustable angular position about the horizontal axis (ϑx) in order to prevent the test head from tilting under its own weight about said horizontal axis (ϑx).

2. Apparatus according to claim 1, characterized in that the orientation device comprises a frame (90) mounted on the block (81) for rotating about the horizontal axis (ϑx), centering members (97) provided on the frame (90) at equal distances from the additional axis (ϑy) and a disk (100) mounted so as to rest on the centering members (97) and to turn about the additional axis (ϑy), the radial arm (12) of the test head (11) being fixed to the disk (100).

3. Apparatus according to claim 2, characterized in that the frame (90) comprises a first part (90a) mounted on the block (81) for rotating about the horizontal axis (ϑx) and adapted to partly encircle the disk (100) and a second part (90b) mounted for pivoting with respect to the first part (90a) between a closed position in which the disk (100) is gripped between the two parts of the frame (90) and an open position in which the disk (100) can be disengaged from the frame (90) with the test head (11) being fixed to the disk.

4. Apparatus according to claim 3, characterized in that the second part (90b) of the frame (90) is mounted on the first (90a) for pivoting about an axis (104) parallel to the additional axis (ϑy), the frame (90) further comprising means (105) for locking the first and second parts (90a, 90b) in closed position.

5. Apparatus according to one of claims 2 to 4, characterized in that the centering members (97) comprise runners arranged all around the additional axis (ϑy) and having surfaces adapted to hold the disk (100) laterally in the direction of the additional axis (ϑy).

6. Apparatus according to one of claims 2 to 5, characterized in that it comprises a hand-operated locking member (110), mounted on the frame (90) so as to prevent the disk (100) from rotating about the additional axis (ϑy).

7. Apparatus according to claim 1, characterized in that the adjusting means (94) comprise hand-adjustable connection means provided between the block (81) and the orientation device (16) for moving the orientation device (16) in rotation, relative to the block (81), about the horizontal axis (ϑx) over a limited range of angular positions.

8. Apparatus according to claim 7, characterized in that the limited range of angular positions is of about 10°.

9. Apparatus according to one of claims 7 and 8, characterized in that the adjusting means (94) comprise an adjustable screw (124) connecting the block (81) to the orientation device (16) so that a manual rotation of the screw (124) causes the rotation of the orientation device (16) about the horizontal axis (ϑx), relative to the block (81).

10. Apparatus according to one of claims 7 and 8, characterized in that the adjusting means (94) comprise a cam (119) mounted on the block (81) for rotating about a pin (118) parallel to the horizontal axis (ϑx), and coming to rest on the orientation device (16) so that a manual rotation of the cam (119) causes the rotation of the orientation device (16) about the horizontal axis (ϑx) relative to the block (81).

11. Apparatus according to one of the preceding claims, characterized in that the positioning means (15) comprise a first support (54) mounted so as to be movable in rotation about a first vertical axis and a second support (70) mounted so as to be horizontally movable relative to the first support (54), the block (81) being mounted for rotating on the second support (70) about a second vertical axis (ϑz).

12. Apparatus according to claim 11, characterized in that the suspension means comprise a first tubular member (20) fixed on a base and a second tubular member (26) mounted so as to slide vertically along the first tubular member (20), the first support (54) being mounted for rotating about the second tubular member (26).

## Patentansprüche

1. Manipulator zum Halten und Drehen eines Prüfkopfs (11) mit Verlängerung durch einen radialen Arm (12), bestehend aus:
- Aufhängungsmitteln (14), um einen Block (81) vertikal beweglich anzubringen;
- Positioniermitteln (15), um den Block (81) horizontal beweglich anzubringen;
- einer Drehvorrichtung (16), um den Prüfkopf an dem Block (81) anzubringen; und
- Ausgleichmitteln (40, 41) zum Ausgleichen des Gewichts des an der Drehvorrichtung angebrachten Prüfkopfs (11);
dadurch gekennzeichnet, daß die Drehvorrichtung (16) an dem Block (81) um eine horizontale Achse (ϑx) drehend angebracht ist und geeignet ist für die Anbringung des radialen Arms (12) des Prüfkopfs (11), der drehbeweglich um eine zusätzliche Achse (ϑy) ist, die senkrecht zur horizontalen Achse (ϑx) verläuft, und daß Einstellmittel (94) vorgesehen sind, um die Drehvorrichtung (16) zum Block (81) in einer einstellbaren, stabilen Winkelposition um die horizontale Achse (ϑx) zu halten, um zu verhindern, daß der Prüfkopf unter Einwirkung seines Gewichts um diese horizontale Achse (ϑx) kippt.

2. Manipulator nach Anspruch 1,
dadurch gekennzeichnet, daß die Drehvorrichtung einen Rahmen (90) aufweist, der um die horizontale Achse (ϑx) drehend an dem Block (81) angebracht ist, sowie Zentrierorgane (97), die an dem Rahmen (90) in gleichen Abständen von der zusätzlichen Achse (ϑy) angeordnet sind, und eine Scheibe (100), die auf den Zentrierorganen (97) gelagert angebracht ist, um sich um die zusätzlichen Achse (ϑy) drehen zu können, wobei der radiale Arm (12) des Prüfkopfs (11) an der Scheibe (100) befestigt ist.

3. Manipulator nach Anspruch 2,
dadurch gekennzeichnet, daß der Rahmen (90) aus einem ersten Teil (90a) besteht, der um die horizontale Achse (ϑx) drehend an dem Block (81) angebracht ist und geeignet ist, die Scheibe (100) teilweise zu umgeben, und aus einem zweiten Teil (90b), der so angebracht ist, daß er zum ersten Teil (90a) zwischen einer Schließstellung, bei der die Scheibe (100) zwischen den beiden Teilen des Rahmens (90) gehalten wird, und einer geöffneten Stellung, bei der die Scheibe (100) vom Rahmen (90) gelöst werden kann, wobei der Prüfkopf (11) an der Scheibe befestigt ist, schwenkbar ist.

4. Manipulator nach Anspruch 3,
dadurch gekennzeichnet, daß der zweite Teil (90b) des Rahmens (90) auf dem ersten (90a) um eine Achse (104) schwenkbar angebracht ist, die parallel zur zusätzlichen Achse (ϑy) verläuft, wobei der Rahmen (90) des weiteren Mittel (105) aufweist, um den ersten und den zweiten Teil (90a, 90b) in der Schließstellung zu verriegeln.

5. Manipulator nach einem der Ansprüche 2 bis 4,
dadurch gekennzeichnet, daß die Zentrierorgane (97) aus Rollen bestehen, die rings um die zusätzliche Achse (ϑy) angeordnet sind und geeignete Oberflächen besitzen, um die Scheibe (100) seitlich in Richtung der zusätzlichen Achse (ϑy) zu halten.

6. Manipulator nach einem der Ansprüche 2 bis 5,
dadurch gekennzeichnet, daß er ein von Hand zu betätigendes Feststellorgan (110) aufweist, das an dem Rahmen (90) angebracht ist, um ein Drehen der Scheibe (100) um die zusätzliche Achse (ϑy) zu verhindern.

7. Manipulator nach Anspruch 1,
dadurch gekennzeichnet, daß die Einstellmittel (94) von Hand einstellbare Verbindungsmittel aufweisen, die zwischen dem Block (81) und der Drehvorrichtung (16) angeordnet sind, um die Drehvorrichtung (16) zum Block (81) in einem begrenzten Bereich von Winkelstellungen um die horizontale Achse (ϑx) zu verdrehen.

8. Manipulator nach Anspruch 7,
dadurch gekennzeichnet, daß der begrenzte Bereich von Winkelstellungen eine Größenordnung von 10° hat.

9. Manipulator nach einem der Ansprüche 7 und 8,
dadurch gekennzeichnet, daß die Einstellmittel (94) eine Stellschraube (124) aufweisen, die den Block (81) dergestalt mit der Drehvorrichtung (16) verbindet, daß ein Drehen der Schraube (124) von Hand eine Drehbewegung der Drehvorrichtung (16) zum Block (81) um die horizontale Achse (ϑx) bewirkt.

10. Manipulator nach einem der Ansprüche 7 und 8,
dadurch gekennzeichnet, daß die Einstellmittel (94) eine Kurvenscheibe (119) aufweisen, die um eine zur horizontalen Achse (ϑx) parallel verlaufende Achse (118) drehbar an den Block (81) angebracht ist und dergestalt an der Drehvorrichtung (16) anliegt, daß ein Drehen der Kurvenscheibe (119) von Hand eine Drehbewegung der Drehvorrichtung (16) zum Block (81) um die horizontale Achse (ϑx) bewirkt.

11. Manipulator nach einem der vorherigen Ansprüche,
dadurch gekennzeichnet, daß die Positioniermittel (15) ein erstes Stützteil (54) aufweisen, das drehbeweglich um eine erste vertikale Achse angebracht ist, und ein zweites Stützteil (70), das zu dem ersten Stützteil (54) horizontal verschiebbar angebracht ist, wobei der Block (81) um eine zweite vertikale Achse (ϑz) drehbar auf dem zweiten Stützteil (70) angebracht ist.

12. Manipulator nach Anspruch 11,
dadurch gekennzeichnet, daß die Aufhängungsmittel aus einem ersten rohrförmigen Glied (20) bestehen, das auf einem Sockel befestigt ist, und einem zweiten rohrförmigen Glied (26), das vertikal längs des ersten rohrförmigen Glieds (20) gleitend angebracht ist, wobei das erste Stützteil (54) um das zweite rohrförmige Glied (26) drehbar angebracht ist.
